Europäisches Patentamt

European Patent Office

Office européen des brevets

(19)

(11) Numéro de publication: **0 320 524 B1**

(12) **FASCICULE DE BREVET EUROPEEN**

(45) Date de publication de fascicule du brevet:
10.04.91

(21) Numéro de dépôt: 87118593.0

(22) Date de dépôt: 15.12.87

(51) Int. Cl.⁵: **G04B 39/00, C30B 33/00**

(54) Glace pour montre et procédé de fabrication d'une telle glace.

(43) Date de publication de la demande:
21.06.89 Bulletin 89/25

(45) Mention de la délivrance du brevet:
10.04.91 Bulletin 91/15

(84) Etats contractants désignés:
**DE FR GB**

(56) Documents cités:
**DE-B- 2 614 566**

**CHEMICAL ABSTRACTS, vol. 102, 1985, page 817, résumé no. 37099q, Columbus, Ohio, US; P.J. BURNETT et al.: "Changing the surface mechanical properties of silicon and sapphire (alpha-Al2O3) by ion implantation"**

**CHEMICAL ABSTRACTS, vol. 102, 1985, page 277, résumé no. 83243e, Columbus, Ohio, US; T. HIOKI et al.: "Strengthening of alumina by ion implantation", & J. MATER. SCI. LETT. 1984, 3(12), 1099-101**

**J. APPL. PHYS., vol. 54, no. 2, février 1983, pages 683-685, American Institute of Physics, New York, US; H. NARAMOTO et al.: "Ion implantation and thermal annealing of**

**alpha-Al2O3 single crystals"**

(73) Titulaire: **Montres Rado S.A.**
**Bielstrasse 43**
**CH-2543 Lengnau b. Biel(CH)**

(72) Inventeur: **Loth, Eric**
**Rue du Stand 105**
**CH-2502 Bienne(CH)**

(74) Mandataire: **de Montmollin, Henri**
**ICB Ingénieurs Conseils en Brevets SA Passage Max Meuron 6**
**CH-2001 Neuchâtel(CH)**

# Description

La présente invention a pour objet une glace en saphir pour montre. Cette glace comporte des surfaces destinées à former une partie des surfaces extérieures de la montre. Ce type de glace est réputé conférer à la montre un aspect esthétique remarquable et durable dans le temps à cause de la grande résistance à l'abrasion du saphir. La pratique a toutefois démontré que le risque de rupture de ce type de glace n'est pas négligeable. Ce risque est d'autant plus grand que la glace est mince. Or on sait que, pour réaliser des montres esthétiques, les créateurs cherchent à rendre la montre aussi mince que possible.

La présente invention a également pour objet un procédé de fabrication de glace de montre telle que définie ci-dessus.

Le but de la présente invention est de réaliser une glace de montre ayant une meilleure résistance à la rupture. Pour atteindre ce but, une partie de la glace destinée à former au moins partiellement la surface extérieure de la montre comprend une zone dans laquelle le saphir présente une couche superficielle dans laquelle l'ordre cristallin à grande distance est détruit.

Une telle glace peut être réalisée au moyen du procédé revendiqué, dans lequel, après avoir découpé la glace dans un bloc de saphir et poli ses faces, on soumet une zone appartenant à une partie de la glace destinée à former au moins partiellement la surface extérieure de la montre à un traitement ayant pour effet de détruire l'ordre cristallin à grande distance du saphir dans la couche superficielle de ladite zone.

Dans une forme de mise en oeuvre préférée, ce traitement comporte un bombardement ionique d'ions ayant un numéro atomique compris entre 5 et 45, voire même entre 3 et 80, selon le Tableau de Mendeleïev.

Il était certes connu que l'implantation d'ions dans un cristal de saphir permet d'accroître la dureté du saphir et de réduire le risque de rupture. Une telle approche est développée dans l'article intitulé Ion implantation and thermal annealing of alpha-Al$_2$O$_3$ single crystals (J. APPL. Phys. 54(2), février 1983). Cet article montre notamment que l'implantation d'ions de chrome dans le saphir permet d'augmenter la dureté de surface de plus de 40 % et de réduire le risque de cassure de 15%. Ce résultat a été obtenu en implantant des ions de chrome à la température ordinaire, avec une énergie comprise entre 280 et 300 keV la densité d'ions étant comprise entre 10$^{16}$ et 10$^{17}$ ions par cm$^2$. Une telle opération a pour effet de modifier considérablement la structure cristalline de la couche superficielle, à un point tel qu'on ne retrouve pratiquement plus les paramètres propres à la structure cristalline du saphir. Cette couche peut être considérée comme ayant une structure amorphe, ou tout au moins une structure dans laquelle l'ordre cristallin à grande distance est détruit.

Il est bien évident que la modification de la structure cristalline du saphir dans une couche de l'ordre de 1 micromètre d'épaisseur est susceptible de modifier les caractéristiques optiques du cristal. Cet aspect n'est pas abordé dans l'article cité ci-dessus. Néanmoins, des essais ont montré une légère opacification du cristal, incompatible avec les applications horlogères, puisque le saphir doit être parfaitement transparent pour permettre la lecture des informations horaires.

La pratique a démontré que dans le 80 % environ des cas de rupture des glaces de montre en saphir, l'amorce de la rupture provenait d'une des faces latérales de la glace. En conséquence, il est possible d'obtenir une sensible amélioration des caractéristiques mécaniques de la glace en ne modifiant la structure du saphir que dans une partie de sa surface.

L'invention sera mieux comprise à la lecture de la description qui va suivre, faite en référence aux dessins, dans lesquels:

- Les figures 1 et 2 représentent une montre munie d'une glace selon l'invention, en plan, respectivement en coupe;
- La figures 3 représente schématiquement un dispositif pour le traitement des glaces; et
- Les figures 4 et 5 illustrent deux autres modes d'exécution de glaces selon l'invention.

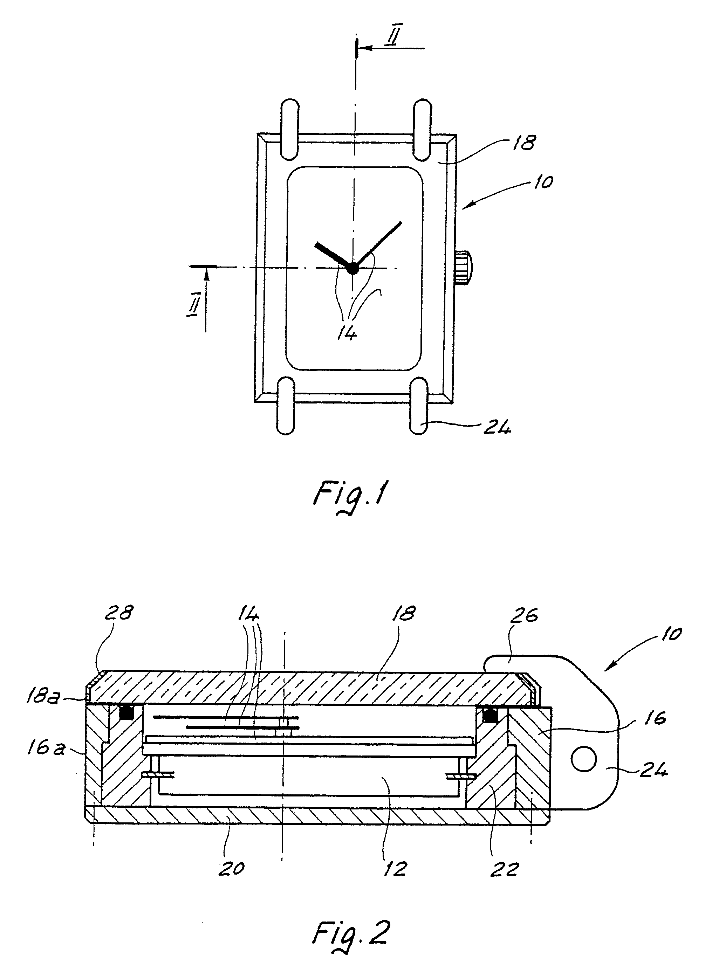

La montre représentée aux figures 1 et 2 comporte une boîte 10, un mouvement 12 et des moyens d'affichages 14, en l'occurence des aiguilles et un cadran. La boîte 10 comprend une carrure 16, une glace 18, en saphir, un fond 20 et un cercle d'encageage 22. La carrure 16 est munie de quatre cornes 24 qui se prolongent au-dessus du corps de la carrure et forment des griffes 26 définissant, avec les corps de la carrure, une glissière à l'intérieur de laquelle la glace 18 est logée. Le fond 20 est fixé à la carrure 16 par des vis non représentées au dessin. Il s'appuie en outre contre le cercle d'encageage 22. Ce dernier s'étend sur toute la hauteur du corps de la carrure 16 et est en appui contre la glace 18. De la sorte, lorsque le fond 20 est fixé au moyen des vis, le cercle d'encageage 22 exerce une pression sur la glace 18 qui s'appuie sur les griffes 26. Cette construction est bien connue de l'homme du métier, aussi est-il inutile de la décrire de manière plus explicite. Il faut toutefois encore relever que dans cette construction la glace 18 recouvre complètement la carrure 16. Cela revient à dire que les faces latérales 16a de la carrure et 18a de la glace sont alignées. comme cette glace 18 est en saphir, elle est pratiquement inrayable, étant donné la dureté de ce matériau. La montre est de la sorte particulièrement bien protégée.

Toutefois, ainsi que cela a été dit précédemment, il se trouve que parfois des glaces se cassent durant le porter. Ceci est d'autant plus gênant que le prix de la glace est élevé. On a constaté que dans 80% des cas environ, les amorces de ruptures se trouvaient sur les faces latérales de la glace. Cela peut se comprendre puisqu'on peut calculer, par la théorie de la mécanique de la rupture qu'une raie de 2μm de profondeur seulement peut provoquer une rupture de toute la plaque dès lors que l'endroit où se trouve la raie est soumis à une contrainte dépassant la limite élastique. Or, les faces latérales de la glace sont la partie de la boîte mécaniquement la plus mise à contribution, c'est-à-dire la plus susceptible d'être rayée et la plus soumise à des chocs.

Pour palier cet inconvénient, les faces latérales 18a de la glace 18 comportent une couche superficielle 28 dans laquelle la structure cristalline du saphir a pratiquement disparu. Cette disparition peut être obtenue par des procédés qui seront décrits ultérieurement. La couche 28 a une épaisseur très faible, typiquement de 1μm. Elle augmente la microdureté du saphir, déjà considérable, de 10 à 40 % environ. Elle permet en outre de réduire le risque de rupture. Ceci semble dû au fait que la structure fortement perturbée de cette couche 28 empêche la propagation de fissures au travers du cristal. Elle forme en quelque sorte une bague de protection qui entoure la glace et la protège dans sa partie la plus exposée. A cause de sa structure profondément modifiée, il est bien évident que le comportement optique de cette couche 28 n'est plus le même que celui du saphir tel qu'il se présente dans le reste de la plaque. Ceci n'est pas gênant du fait que la couche 28 ne doit pas nécessairement recouvrir toute la glace, la couverture des faces latérales et/ou des arêtes apparentes permettant déjà une réelle amélioration de la solidité de la glace.

Pour réaliser une glace telle que définie ci-dessus, on peut faire appel à plusieurs techniques telles que l'irradiation à l'aide d'un faisceau d'électrons ou d'un faisceau laser ou telle que celle qui est connue sous le nom d'implantation ionique. Cette dernière technique consiste à faire pénétrer des ions du matériau à implanter dans le matériau de la glace, en les projetant violemment contre la surface de ce dernier matériau.

Lorsque le matériau à implanter est solide, les ions sont obtenus par projection d'électrons sur une cible comprenant ce matériau, ce qui provoque un arrachement des ions. Lorsque le matériau à implanter est gazeux, les ions sont obtenus en soumettant ce matériau à une décharge électrique. Les ions ainsi obtenus sont ensuite accélérés par un champ électrique puis projetés sur l'objet à traiter. Cette opération est effectuée sous vide et à une température voisine de la température ordinaire. Pour un matériau et un type d'ions donnés, l'énergie cinétique des ions au moment de l'impact définit sensiblement l'épaisseur de la couche dont la structure est modifiée alors que la densité d'ions définit le degré de modification de la structure de cette couche.

Dans le cas du saphir, différents types d'ions peuvent être utilisés. Des essais ayant donné des résultats satisfaisants ont été effectués en implantant des ions de chrome, de zirconium, de titane et d'azote. Par exemple, en implantant des ions de chrome ou de titane ayant une énergie de 300 keV et pour une densité de $10^{16}$ à $10^{17}$ ions par cm², il est possible d'obtenir une augmentation de la dureté de 35% environ. En implantant des ions de zirconium ayant une énergie de 150 keV et pour une densité de 4. $10^{16}$ ions par cm², il est possible d'obtenir une augmentation de la dureté atteignant 40%.

Enfin, en implantant des ions d'azote ayant une énergie de 150 keV avec une densité de $10^{18}$ ions par cm², il est possible d'obtenir une augmentation de la dureté de 10 % environ.

Dans tous les cas, l'augmentation de la dureté s'accompagne d'une augmentation de la ténacité de la glace, c'est-à-dire d'une diminution de sa sensibilité à l'effet de rayures. Cette amélioration est due au désordre que crée le bombardement de ces ions qui pénètrent profondément à l'intérieur du cristal; la couche perturbée peut atteindre 1μm, ce qui représente quelques $10^3$ couches atomiques. Dans cette couche, la densité d'ions implantés a une valeur moyenne voisine de $10^{-2}$ environ. Un tel traitement a pour effet de désordonner la structure cristalline de sorte que les paramètres qui définissent celle du saphir ne se retrouvent pas. Plus même, cette structure a atteint un tel niveau de désordre qu'elle peut être qualifiée d'amorphe.

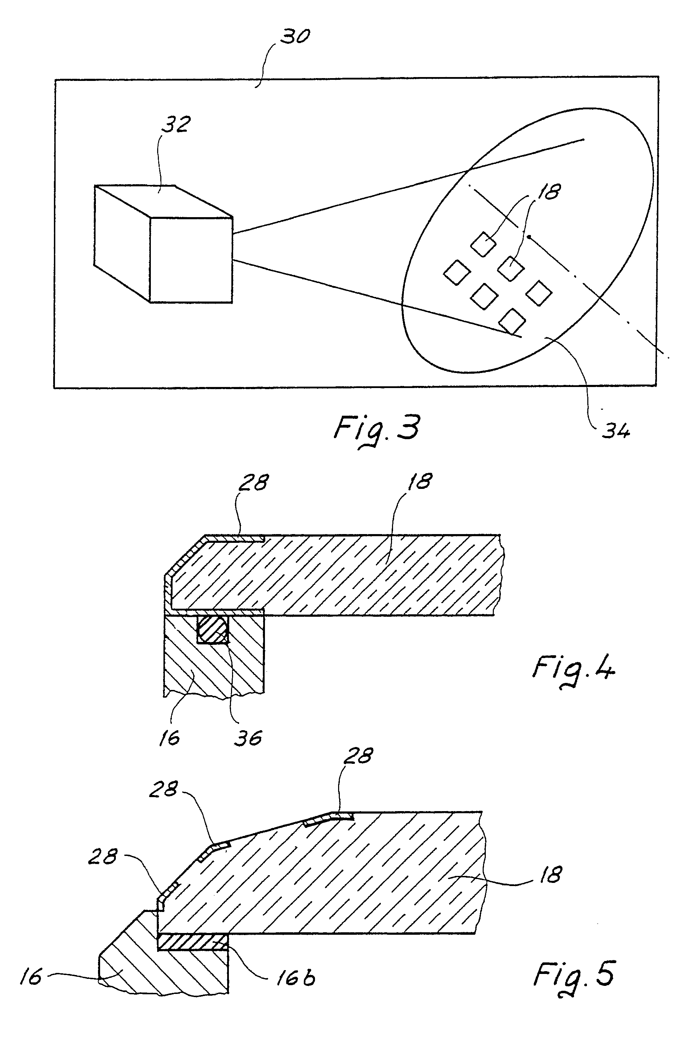

Pour effectuer cette opération, on utilise une machine schématiquement représentée à la figure 3. Cette machine comporte une enceinte étanche schématiquement représentée par le rectangle 30 à l'intérieur de laquelle se trouve une source d'ions 32 et une table 34. La table 34 porte les glaces 18 à traiter. Celles-ci peuvent être fixées par collage, la température de travail étant suffisamment faible. Il est aussi possible d'utiliser des moyens mécaniques. Les glaces 18 sont fixées par leur face inférieure. De la sorte, leur face supérieure et leurs faces latérales sont dégagées. Les faces supérieures des glaces 18 sont revêtues d'une couche de protection, à l'exception de la périphérie. La table 34 est montée pivotante sur un axe, de manière à ce qu'elle puisse tourner durant l'opération d'implantation.

Après que les glaces, revêtues de leur couche de protection, ont été fixées sur la table et introduites dans l'enceinte 30, cette dernière est mise sous vide. Lorsque le vide désireé est atteint (de l'ordre de 10⁻⁶ mm Hg), les ions sont créés en projetant des électrons sur une cible faite du matériau voulu dont les atomes, ionisés, sont arrachés. Ces ions sont ensuite accélérés au moyen d'un champ électrique et projetés violemment sur la table, c'est-à-dire aussi sur les glaces 18. Ces ions ont une incidence de 30 à 70° par rapport à l'axe de la table. De la sorte et à cause du mouvement rotatif de la table 34, les ions sont implantés dans le saphir dans chacune des faces latérales ainsi que dans la partie périphérique de la face supérieure des glaces 18.

Lorsque la densité d'ions désirée a été atteinte, la projection d'électrons sur la cible est interrompue, la pression est rétablie à l'intérieur de l'enceinte 30 et les glaces 18 enlevées de la table 34 et débarrassées de leur couche de protection. Elles sont prêtes alors à être utilisées.

La partie de montre représentée à la figure 4 comporte une glace 18 qui diffère de celles de la figure 3 du fait que la couche 28 s'étend non seulement sur les faces latérales et sur la périphérie de la surface supérieure, mais encore sur la périphérie de la surface inférieure de la glace. De la sorte et à cause des modifications de ses caractéristiques optiques, cette partie de la couche 28 permet de masquer le joint d'étanchéité 36 que comportent généralement une telle montre, aussi bien dans le domaine du visible (pour des raisons esthétiques) que de l'ultra-violet (pour éviter la détérioration de la matière du joint).

La partie de montre représentée à la figure 5 comporte une glace qui diffère de celle de la figure 3 par sa forme géométrique plus complexe. Par ailleurs, la glace 18 ne s'étend plus jusqu'au bord de la carrure 16, mais est noyée dans une creusure 16b que comporte la surface supérieure de cette dernière. Dans cette configuration, les faces latérales de la glace 18 sont mieux protégées. A cause de sa géométrie plus complexe, cette glace 18 comporte un plus grand nombre d'arêtes. Chacune d'entre elles qui appartient à la surface supérieure de la glace est renforcée par une couche 28 semblable à celles qui ont été décrites ci-dessus. Cette couche 28 s'étend de part et d'autre de l'arête. Elle peut être très étroite, de largeur inférieure même à un millimètre, ou au contraire couvrir entièrement les facettes périphériques que définissent ces arêtes.

**Revendications**

1. Glace en saphir pour montre, comportant une partie destinée à former au moins partiellement la surface extérieure de la montre, caractérisée en ce qu'au moins ladite partie comprend une zone dans laquelle le saphir présente une couche superficielle dans laquelle l'ordre cristallin à grande distance est détruit.

2. Glace selon la revendication 1, dans laquelle ladite partie présente des arêtes, caractérisée en ce que lesdites arêtes appartiennent à ladite zone.

3. Glace selon la revendication 1 ou 2, comportant en outre des faces latérales destinées à former une partie des faces latérales de la montre, caractérisée en ce que ladite zone occupe les faces latérales de la glace.

4. Procédé de fabrication d'une glace de montre selon l'une quelconque des revendications 1 à 3, dans lequel on découpe la glace de montre dans un bloc de saphir et on polit ses faces, caractérisé en ce qu'on soumet une zone appartenant à une partie de la glace destinée à former au moins partiellement la surface extérieure de la montre à un traitement ayant pour effet de détruire l'ordre cristallin à grande distance du saphir dans la couche superficielle de ladite zone.

5. Procédé selon la revendication 4, caractérisé par le fait que ledit traitement comporte un bombardement ionique d'ions ayant un numéro atomique compris entre 5 et 45.

6. Procédé selon la revendication 5, caractérisé en ce que les ions sont choisis parmi des ions de chrome, de zirconium, de titane et d'azote.

7. Procédé selon la revendication 6, caractérisé en ce que ledit bombardement ionique a une densité de 10¹⁶ à 10¹⁸ ions par cm² et en ce que l'énergie d'implantation est comprise entre 150 et 300 keV.

**Claims**

1. A sapphire watch glass consisting of a part designed to form at least partially the exterior surface of the watch wherein at least said part comprises a zone in which the sapphire presents a superficial layer in which the crystalline structure has been destroyed over a substantial thickness.

2. A glass according to claim 1 wherein said part presents ridges wherein said ridges belong to said zone.

3. A glass according to claim 1 or claim 2 consisting inter alia of lateral faces designed to form a part of the lateral faces of the watch wherein said zone occupies the lateral faces of the glass.

4. A process for the manufacture of a watch glass according to any one of claims 1 to 3 in which the watch glass is cut from a block of sapphire and its faces are polished wherein a zone belonging to one part of the watch designed to form at least partially the exterior surface of the watch is subjected to a treatment designed to destroy the crystalline structure over a substantial thickness of the sapphire in the superficial layer of said zone.

5. A process according to claim 4 wherein said treatment comprises ionic bombardment of ions having an atomic number between 5 and 45.

6. A process according to claim 5 wherein the ions are selected from the ions of chromium, zirconium, titanium and nitrogen.

7. A process according to claim 6 wherein said ionic bombardment has a density of from 1016 to 1018 ions per $cm^2$ and where the energy of implantation is between 150 and 300 keV.


## Ansprüche

1. Uhrglas aus Saphir, umfassend eine Partie, bestimmt zum mindestens teilweise Bilden der Außenoberfläche der Uhr, dadurch gekennzeichnet, daß zumindest die genannte Partie eine Zone umfaßt, in der der Saphir eine Oberflächenschicht aufweist, in der die kristalline Fernordnung zerstört ist.

2. Glas nach Anspruch 1, bei dem die genannte Partie Vorsprünge aufweist, dadurch gekennzeichnet, daß diese Vorsprünge zu der genannten Zone gehören.

3. Glas nach Anspruch 1 oder 2, umfassend ferner Seitenflächen, bestimmt zum Bilden einer Partie der Seitenflächen der Uhr, dadurch gekennzeichnet, daß die genannte Zone die Seitenflächen des Glases einnimmt.

4. Verfahren zum Herstellen eines Uhrglases nach einem der Ansprüche 1 bis 3, bei dem man das Uhrglas aus einem Saphirblock schneidet und seine Seiten poliert, dadurch gekennzeichnet, daß man eine Zone, die zu einer Partie des Glases gehört, welche zum mindestens teilweise Bilden der Außenoberfläche der Uhr bestimmt ist, einer Behandlung mit der Wirkung unterwirft, daß die kristalline Fernordnung des Saphirs in der Oberflächenschicht der genannten Zone zerstört wird.

5. Verfahren nach Anspruch 4, dadurch gekennzeichnet, daß die Behandlung ein Ionenbombardement mit Ionen mit einer Atomzahl zwischen 5 und 45 umfaßt.

6. Verfahren nach Anspruch 5, dadurch gekennzeichnet, daß die Ionen aus den Ionen von Chrom, Zirkon, Titan und Stickstoff ausgewählt sind.

7. Verfahren nach Anspruch 6, dadurch gekennzeichnet, daß das Ionenbombardement eine Dichte von $10^{16}$ bis $10^{18}$ Ionen pro $cm^2$ aufweist und daß die Implantationsenergie zwischen 150 und 300 keV liegt.

Fig.1

Fig.2

Fig.3

Fig.4

Fig.5